(19) Europäisches Patentamt
European Patent Office
Office européen des brevets

(11) Numéro de publication: **0 001 943**
A1

## (12) DEMANDE DE BREVET EUROPEEN

(21) Numéro de dépôt: 78400140.6

(22) Date de dépôt: 19.10.78

(51) Int. Cl.²: **C 01 B 33/00**
C 23 C 11/06, H 01 L 31/18

(30) Priorité: 04.11.77 FR 7733171

(43) Date de publication de la demande:
16.05.79 Bulletin 79/10

(84) Etats contractants désignés:
BE CH DE FR GB NL

(71) Demandeur: RHONE-POULENC INDUSTRIES
22, avenue Montaigne
F-75008 Paris(FR)

(72) Inventeur: Anglerot, Didier
17, rue Labois-Rouillon
F-75019 - Paris(FR)

(74) Mandataire: Savina, Jacques et al,
RHONE POULENC Service Brevets Chimie et Polymères
B.P. 753
F-75360 Paris Cedex 08(FR)

(54) **Silicium polycristallin en couche mince pour conversion photovoltaïque.**

(57) La présente invention concerne un procédé de fabrication de silicium polycristallin en couche mince.

Selon une mise en oeuvre particulière de l'invention, le procédé consiste à réduire un composé du silicium à l'état gazeux par un métal réducteur à l'état liquide choisi parmi le groupe comprenant: l'aluminium, le gallium et l'indium, la température de la réduction étant comprise entre 700 et 800°C et la pression totale de 1 atmosphère.

Le silicium obtenu par ce procédé est applicable à la conversion photovoltaïque.

EP 0 001 943 A1

0001943

1

## SILICIUM POLYCRISTALLIN EN COUCHE MINCE POUR CONVERSION PHOTO-VOLTAIQUE

La présente invention a pour objet un procédé de fabrication de silicium pour la conversion photovoltaïque et concerne plus particulièrement la préparation de silicium polycristallin en couche mince par réduction d'un composé du silicium.

La préparation de silicium très pur par réduction de tétrachlorure de silicium par le zinc à l'état vapeur est connue (Lyon, Olson et Lewis Trans. Electrochem. Soc. 96 (1949) 359). Cette réaction a lieu à 950° C, les cristaux obtenus ont la forme d'aiguilles. Ce procédé présente les inconvénients de nécessiter l'utilisation d'une température de réaction élevée, d'être difficile à mettre en oeuvre du fait de l'existence de zinc à l'état de vapeur qui entraîne la nécessité d'utiliser un rebouilleur, et de ne pas être directement exploitable, le silicium obtenu sous forme d'aiguilles devant être refondu au-dessus de 1400° C pour être utilisable.

La demanderesse a découvert un procédé de fabrication de silicium qui obvie aux inconvénients précités et qui présente notamment les avantages d'être utilisable à une température en général voisine de 750° C, d'être aisé à mettre en oeuvre et de permettre une exploitation facile pour la fabrication de photopiles, le silicium pouvant être directement recueilli sous forme d'une couche polycristalline sur un substrat éventuellement conducteur.

La présente invention concerne, en effet, un procédé de fabrication de silicium polycristallin en couche mince par réduction d'un composé du silicium à l'état gazeux par un métal réducteur caractérisé en ce que ce métal réducteur est choisi parmi le groupe comprenant l'aluminium, le gallium et l'indium, ledit métal étant à l'état liquide et les conditions opératoires étant choisies telles que le composé du métal réducteur formé lors de la réduction soit à l'état gazeux.

Le composé du silicium mis en oeuvre selon l'invention peut être tout composé du silicium étant à l'état gazeux dans les conditions de la réduction et qui permet la formation d'un composé du métal réducteur, également à l'état gazeux, dans ces conditions. Selon une mise en oeuvre particulière de l'invention, on utilisera les halogénosilanes et, de préférence, le tétrachlorosilane car ce dernier, facilement accessible sur le plan industriel, peut, par ailleurs, être aisément purifié par des méthodes conventionnelles.

Le composé du silicium est introduit à l'état gazeux dans le milieu réactionnel, il peut être mis en oeuvre à l'état pur ou éventuellement dilué dans un gaz pur et anhydre. Parmi ces gaz on peut citer notamment l'azote, l'argon, l'hydrogène ou des mélanges de ceux-ci ; le gaz diluant ne devant pas réduire le composé du silicium dans les conditions de la réaction et devant conserver au milieu son caractère réducteur. Le rapport en volume de gaz diluant par rapport au composé du silicium peut varier dans de larges limites, pratiquement des rapports variant de 0 à 1000 conviennent, on mettra en oeuvre de préférence des rapports variant de 0,5 à 5 .

La pression partielle du composé du silicium n'est pas un facteur critique selon l'invention, elle peut varier dans de larges limites, pratiquement une pression partielle comprise entre $10^{-3}$ atmosphère et 1 atmosphère convient aux fins de l'invention.

Le métal réducteur est mis en oeuvre selon l'invention à l'état liquide.

Selon une variante de l'invention, il peut être envisagé d'effectuer la réaction sur un support solide mouillé par la phase liquide et dont les éléments ne diffusent pas dans la couche de silicium.

Les conditions opératoires du procédé selon l'invention doivent être telles que le composé du silicium soit à l'état gazeux, que le métal réducteur soit à l'état liquide et que le

3

0001943

le composé du métal réducteur formé lors de la réaction soit à l'état gazeux. Une température comprise entre la température de fusion du métal réducteur et 900°C et, de préférence, de 700 à 800°C ainsi qu'une pression totale comprise entre $10^{-3}$ et 1 atmosphère et, de préférence, d'une atmosphère conviennent aux fins de l'invention. De plus, il est nécessaire d'éviter la présence de toute trace d'humidité ou d'oxygène dans le milieu réactionnel.

Après refroidissement, le silicium est obtenu sous forme d'une mince couche polycristalline sur le métal réducteur n'ayant pas complètement réagi ou sur un autre substrat éventuellement quand tout le métal réducteur a disparu.

La mince couche de silicium polycristallin obtenue ne présente qu'un seul grain dans l'épaisseur, cette caractéristique permet notamment l'application du procédé selon l'invention à la fabrication de silicium pour la conversion photovoltaïque. La taille des cristaux obtenus peut atteindre un millimètre ; généralement, pour l'application à la conversion photovoltaïque, l'épaisseur préférée de la couche varie entre 50 et 300 microns.

La présente invention va maintenant être illustrée par l'exemple suivant donné à titre non limitatif.

Exemple.

Dans un réacteur, on a introduit 12 g d'aluminium que l'on chauffe à 750°C. On introduit alors dans le réacteur un courant gazeux constitué d'un mélange tétrachlorosilane-argon à 75 % en volume d'argon à un débit de 16 litres par heure. La pression partielle de tétrachlorosilane est maintenue à la valeur de 190 mm Hg et la pression totale à 760 mm Hg. Le chlorure d'aluminium gazeux formé au cours de la réaction est éliminé par le balayage du courant argon-tétrachlorosilane.

Après 1 h 30, on arrête le courant gazeux et l'on purge le réacteur avec de l'argon. Après refroidissement, on recueille une couche d'environ 150 $\mu$ de silicium polycristallisé sur une matrice d'aluminium.

1      0001943

<u>REVENDICATIONS</u>

1) Procédé de fabrication de silicium polycristallin par réduction d'un composé du silicium à l'état gazeux par un métal réducteur, caractérisé en ce que le métal réducteur est choisi parmi le groupe comprenant l'aluminium, le gallium et l'indium, ledit métal réducteur étant à l'état liquide et les conditions opératoires étant choisies telles que le composé du métal réducteur formé lors de la réaction soit à l'état gazeux.

2) Procédé selon la revendication 1, caractérisé en ce que le composé du silicium mis en oeuvre est tout composé du silicium étant à l'état gazeux dans les conditions de la réduction et qui permet la formation d'un composé du métal réducteur, également à l'état gazeux, dans ces conditions.

3) Procédé selon la revendication 2, caractérisé en ce que le composé du silicium est un halogénosilane.

4) Procédé selon la revendication 3, caractérisé en ce que le composé du silicium est le tétrachlorosilane.

5) Procédé selon l'une quelconque des revendications 2, 3, 4, caractérisé en ce que le composé du silicium est mis en oeuvre à l'état pur ou dilué dans un gaz qui ne le réduit pas dans les conditions de la réaction et qui conserve au milieu son caractère réducteur.

6) Procédé selon la revendication 5, caractérisé en ce que le gaz diluant est choisi parmi le groupe comprenant : l'azote, l'argon, l'hydrogène ou des mélanges de ceux-ci.

7) Procédé selon l'une quelconque des revendications 5 ou 6, caractérisé en ce que le rapport en volume de gaz diluant par rapport au composé du silicium est compris entre 0 et 1000.

8) Procédé selon la revendication 7, caractérisé en ce que le rapport est compris entre 0,5 et 5.

9) Procédé selon l'une quelconque des revendications 2 à 8, caractérisé en ce que la pression partielle du composé du silicium est comprise entre $10^{-3}$ et 1 atmosphère.

10) Procédé selon l'une quelconque des revendications précédentes, caractérisé en ce que la température de la réaction est comprise entre la température de fusion du métal réducteur et 900°C et la pression totale entre $10^{-3}$ et 1 atmosphère.

2

0001943

11) Procédé selon la revendication 10, caractérisé en ce que la température est comprise entre 700 et 800°C et la pression totale est de 1 atmosphère.

12) Procédé selon la revendication 1, caractérisé en ce que la réaction de réduction est effectuée sur un support solide mouillé par la phase liquide et dont les éléments ne diffusent pas dans la couche de silicium.

13) Le silicium obtenu par le procédé de l'une quelconque des revendications précédentes.

14) Application du silicium obtenu selon le procédé de l'une quelconque des revendications 1 à 12 à la conversion photovoltaïque.

## DOCUMENTS CONSIDERES COMME PERTINENTS

| Catégorie | Citation du document avec indication, en cas de besoin, des parties pertinentes | Revendication concernée |
|---|---|---|
| | <u>DE - B - 1 544 305</u> (SANYO ELECTRIC) | 1,2,3 |
| | * Colonne 2, lignes 27-28; colonne 3, lignes 7-23; revendication * | |
| | -- | |
| | JOURNAL OF APPLIED PHYSICS, vol. 48, nr. 9, september 1977 Nijmegen, Netherlands N.W.M. GRAEF et al.: "Enhanced crystallinity of silicon films deposited by CVD on liquid layers (CVDOLL process): Silicon on tin layers in the presence of hydrogen chloride" pages 3937 -3940. | 1 |
| | * Page 3937; page 3939, colonne 2 * | |
| | ----- | |

**CLASSEMENT DE LA DEMANDE (Int Cl ?)**

C 01 B 33/00
C 23 C 11/06
H 01 L 31/18

**DOMAINES TECHNIQUES RECHERCHES (Int. Cl.?)**

C 23 C 11/06
B 01 J 17/26
        17/32
H 01 L 31/18

**CATEGORIE DES DOCUMENTS CITES**

X: particulièrement pertinent

A: arriere-plan technologique

O: divulgation non-ecrite

P: document intercalaire

T: théorie ou principe a la base de l'invention

E: demande faisant interférence

D: document cite dans la demande

L: document cite pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 09-02-1979 | BRACKE |

OEB Form 1503.1   06.78